## Europäisches Patentamt
## European Patent Office
## Office européen des brevets

(19)

(11) Veröffentlichungsnummer: **0 196 555**
**B1**

(12) **EUROPÄISCHE PATENTSCHRIFT**

(45) Veröffentlichungstag der Patentschrift: **14.03.90**

(51) Int. Cl.⁵: **H 05 K 7/14, H 05 K 9/00**

(21) Anmeldenummer: **86103769.5**

(22) Anmeldetag: **20.03.86**

(54) **System zum Einschieben und Herausziehen von in Baugruppenträger einschiebbaren Baugruppen.**

(30) Priorität: **29.03.85 DE 3511458**
**13.11.85 DE 3540262**

(43) Veröffentlichungstag der Anmeldung:
**08.10.86 Patentblatt 86/41**

(45) Bekanntmachung des Hinweises auf die
Patenterteilung:
**14.03.90 Patentblatt 90/11**

(84) Benannte Vertragsstaaten:
**AT BE CH DE FR GB IT LI NL SE**

(56) Entgegenhaltungen:
**EP-A-0 129 883**
**DE-A-2 554 106**
**DE-A-2 653 468**
**DE-A-2 743 194**

(73) Patentinhaber: **Licentia Patent-Verwaltungs-GmbH**
**Theodor-Stern-Kai 1**
**D-6000 Frankfurt/Main 70 (DE)**

(72) Erfinder: **Haxel, Gerd, Ing. grad.**
**Danziger Strasse 38**
**D-6453 Seligenstadt (DE)**
Erfinder: **Hörbe, Siegfried**
**An der Hohl 3**
**D-6393 Wehrheim 1 (DE)**

(74) Vertreter: **Lertes, Kurt, Dr. et al**
**Licentia Patent-Verwaltungs-GmbH Theodor-Stern-Kai 1**
**D-6000 Frankfurt/M 70 (DE)**

Courier Press, Leamington Spa, England.

## Beschreibung

Die Erfindung bezieht sich auf ein System zum Einschieben und Herausziehen von in Baugruppenträger einschiebbaren Steckbaugruppen, deren Längsränder je in eine Nut eines oberen und eines unteren Führungshalters einsetzbar sind und die in eingeschobenen Zustand durch einen Winkelhebel am Baugruppenträger arretierbar sind, dessen einer Hebelarm als Handhabe ausgebildet ist und der an der Seite eines an der jeweiligen Steckbaugruppe befestigten Metallbügels schwenkbar befestigt und mit dem anderen Hebelarm an Anschlagflächen andrückbar ist, wobei in eingeschobenem Zustand der jeweiligen Steckbaugruppe zur Herstellung einer voreilenden Messekontaktverbindung zwischen elektrisch leitenden Teilen der Steckbaugruppe und Profilschienen des Baugruppenträgers ein Messerkontakt des an der Steckbaugruppe befestigten Metallbügels mit einer leitend mit der Profilschiene verbundenen Metallfeder in Kontakt steht.

Ein System der eingangs beschriebenen Gattung ist bereits bekannt (EP—A—0 129 883). Dieses System enthält elektrisch leitende, an den Ecken der Frontkante einer Steckbaugruppe befestigte Endstücke, an denen die Winkelhebel befestigt sind. Die Endstücke sind mit elektrisch leitenden Frontleisten der Steckbaugruppen verbunden. Ferner sind Kontaktmittel zur Verbindung von Masseleitern der Steckbaugruppen, der Frontleisten und von Abschirmungen mit dem auf Massepotentiel liegenden Baugruppenträger vorgesehen.

An den Endstücken sind zungenförmige Kontaktflächen angebracht, die jeweils bei eingeschobener Baugruppe mit Blattfedern elektrisch verbunden sind, die sich in nach vorne offenen Hohlräumen von frontseitigen, parallel angeordneten Profilschienen des Baugruppenträgers befinden. Mit den Winkelhebeln, deren einer Hebelarm sich an oder in einer Profilschiene abstützt und deren anderer Hebelarm als Handhabe ausgebildet ist, werden die Steckbaugruppen unter Überwindung der Reibungskräfte zwischen den vielpoligen Steckverbindern der Baugruppe und der Rückseitenverdrahtung überwunden. Eine am Hebelarm des jeweiligen Winkelhebels angeordnete Nase greift in eine Nut in der Profilleiste ein. Eine vom Hebelarm ausgehende Rastfeder greift mit einer Nase hinter eine Kante einer Öffnung im Endstück und verriegelt die Baugruppe im Baugruppenträger.

Der Erfindung liegt die Aufgabe zugrunde, ein System der eingangs beschriebenen Gattung derart weiterzuentwickeln, daß an den gleichen Stellen des Baugruppenträgers entweder Steckbaugruppen, die durch Winkelhebel im Baugruppenträger arretierbar sind und Habelarme sowie Metallbügel mit Messerkontakten aufweisen, oder Steckbaugruppen eingesetzt werden können, die an den Profilschienen anschraubbare Frontplatten enthalten.

Die Aufgabe wird erfindungsgemäß durch die im Anspruch 1 beschriebenen Maßnahmen gelöst. Die im Anspruch 1 angegebene Vorrichtung hat den Vorteil, daß bekannte Profilschienen, wie sie z.B. in der DE—B—26 53 468 beschrieben sind, und auch bekannte Führungshalter, beispielsweise der in der DE—B—25 54 108 beschriebenen Art, für die Halterung der Federn verwendet werden können. Beim Einschieben des Messerkontakts treten aufgrund des gabelförmigen Federkontakts Krafte in der Verschieberichtung auf. Die Profilschienen werden daher in derjenigen Richtung beansprucht, an der sie ihr größtes Widerstandsmoment haben. Durch die vorstehend beschriebene Vorrichtung wird daher eine günstige Kraftverteilung in den Profilschienen erreicht.

Vorzugsweise enthält die Metallfeder einen U-förmigen Abschnitt, der unter Federvorspannung in eine Profilausnehmung der Profilschiene eingedrückt ist, deren Boden Löcher enthält, in die Führungsstifte der Führungshalter ragen. Durch die Federvorspannung entsteht ein besonders guter Kontakt zwischen der Metallfeder und der beispielsweise aus Aluminium bestehenden Profilschiene. Die Metallfeder wird fest in ihrer Lage fixiert, so daß sie auch höheren Kräften, die über, den Federkontakt übertragen werden, ohne Veränderung ihrer Lage standhält.

Es ist günstig, wenn neben dem jeweiligen Führungshalter ein Klemmkörper an der Profilschine befestigt ist, der je eine beim Einschieben und Herausziehen des Baugruppenträgers mit dem einen Ende des Winkelhebels in Berührung stehende Andrückfläche enthält. Aufgrund des Klemmkörpers ist keine besondere Anpassung der Profilschiene an den Winkelhebel notwendig. Es können daher Steckbaugruppen üblicher Art neben den mit Ziel- und Einsteckhilfen versehenen Steckbaugruppen verwendet werden.

Bei einer zweckmäßigen Ausführungsform weist der Klemmkörper einen die rückwärtige Seite der Profilschiene ungreifenden, federnden Rasthaken und einen gegen eine der Rückseite benachbarten Vorsprung der T-förmigen Profilausnehmung angedrückten Rasthaken auf. Die Klemmvorrichtung läßt sich durch Andrücken an die Profilschiene von Hand schnell und einfach montieren. Wenn der Boden des Klemmkörpers an der Profilschine anliegt, schnappen die Rasthaken an den jeweiligen Kanten ein.

Bei einer bevorzugten Ausführungsform weist der Klemmkörper einen federnden Bügel auf, in dessen Öffnung der eine Hebelarm ragt, wobei arm anderen Hebelarm eine Kante angeordnet ist, mit der der Bügel aus dem Verschiebeweg des Winkelhebels herausdrückbar ist. Die jeweilige Steckbaugruppe ist damit gegen ein unbeabsichtigtes Herausziehen gesichert.

Eine besonders günstige Ausfürhungsform ist derart ausgebildet, daß der Metallbügel an der Frontplatte der Steckbaugruppe befestigt ist und einen auf seiner Außenseite mit einer Wand der Führungsnut des Führungshalters fluchtenden Schenkel aufweist, an dem eine in die Führungsnut einsetzbare Leiterplatte anliegt, und daß an die Innenseite des Schenkels der Winkelhebel angrenzt. Der Abstand zwischen der Leiterplatte und dem Winkelhebel ist bei dieser Vorrichtung nur klein. Es entstehen deshalb beim Einschieben und Herausziehen der Steckaugruppen nur geringe Momente, die die Leiterplatte und damit die Frontplatte auf Biegung beanspruchen.

Wenn die Steckbaugruppe in der Führungsnut durch Betätigung des Winkelhebels verschoben wird, wirken auf die Leiterplatte nur geringe Kräfte senkrecht zur Längsrichtung der Führungsnut ein. Daher sind die Leiterplatten leichtgängig in der jeweiligen Führungsnut verschiebbar. Darüber hinaus lassen sich die Kontakte des Steckverbinders an den rückwärtigen Enden der jeweiligen Leiterplatte ohne Schwierigkeiten in das an der Rückseite des Baugruppenträgers angebrachten Gegensteckelement einfügen.

Vorteilhafterweise weist der jeweilige Führungshalter eine gegen den vorderen Rand der Profilschiene zurückgesetzte Stirnseite als eine Anschlagfläche für das Ende des einen Hebelarms des Winkelhebels und einen in Höhe der der Profilschiene abgewandten Seite vom Führungshalter vorspringenden die Stirnseite umgreifenden federnden Bügel auf, dessen Jochinnenseite als andere Anschlagfläche für das Ende eines Hebelarms des Winkelhebels ausgebildet ist, und daß das Joch des Bügels mit dem anderen Hebelarm des Winkels in der Ausziehlage des Winkelhebels in Richtung der Profilschiene drückbar ist. Der Bügel sperrt in seiner einen Endlage die Leiterplatte gegen die Heruasnahme aus er Führungsnut, wenn der Winkelhebel nicht betätigt wird. Bei Betätigung des Winkelhebels gibt der Bügel die Leiterplatte frei, so daß die Steckbaugruppe aus dem Baugruppenträger herausgezogen werden kann.

Bei einer anderen zweckmäßigen Ausführungsform enthält der Führungshalter an einem Ende einen seitlich vorspringenden Haltekörper für die Metallfeder, deren Federkontakte in einer gegen die Baugruppenfrontseite offenen Aussparung angeordnet sind und deren von den Federkontakten abgesetzter Abschnitt einen in eine Nut der Profilschiene ragenden federnden Bogen aufweist, an dessen beiden angrenzenden Abschnitten die Metallfeder eingespannt ist. Bei dieser Anordnung wird ein unter Federvorspannung stehender Kontakt zwischen der Metallfeder und der Profilschiene hergestellt. Hieraus ergibt sich ein niedriger Kontaktübergangswiderstand.

Vorzugsweise weist die Metallfeder wenigstens eine Noppe auf, die in Ausnehmungen des Haltekörpers eingesetzt sind. Die Metallfeder läßt sich bei dieser Ausführungsform mit dem Führungshalter zu einer selbständigen Einheit verbinden, die danach als Ganzes an der Profilschiene befestigt wird.

Die Erfindung wird im folgenden anhand eines in einer Zeichnung dargestellten Ausführungsbeispiels näher beschrieben, aus dem sich weitere Merkmale sowie Vorteile ergeben.

Es zeigen:

Fig. 1 einen Querschnitt durch ein System zum lösbaren Arretieren von in Baugruppenträgern einschiebbaren Steckbaugruppen und zum Herstellen voreilender Massekontaktverbindungen zwischen elektrisch leitenden Teilen der Steckbaugruppe und Profilschienen.

Fig. 2 die in Fig. 1 dargestellte Vorrichtung von oben, teilweise im Schnitt,

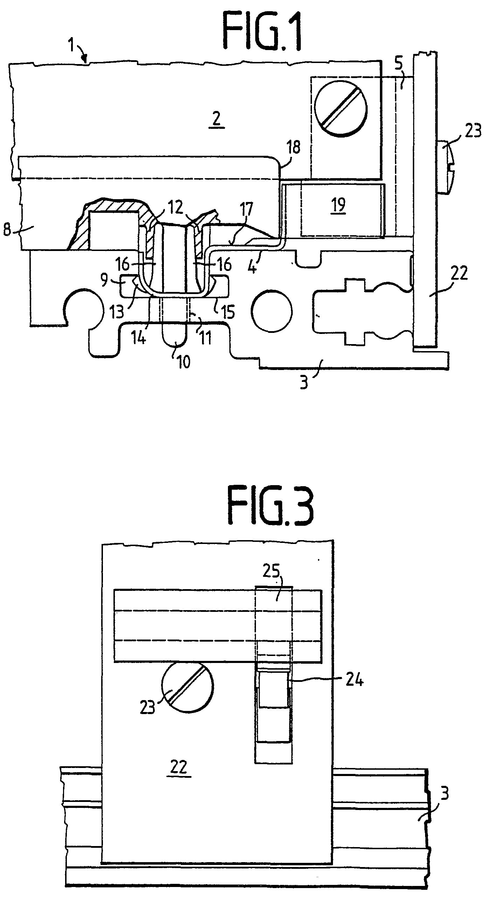

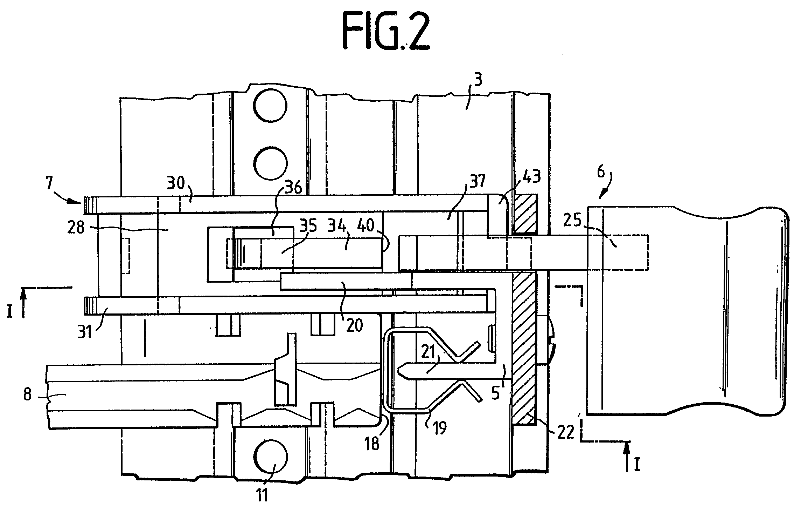

Fig. die in Fig. 1 dargestellte Vorrichtung von vorne,

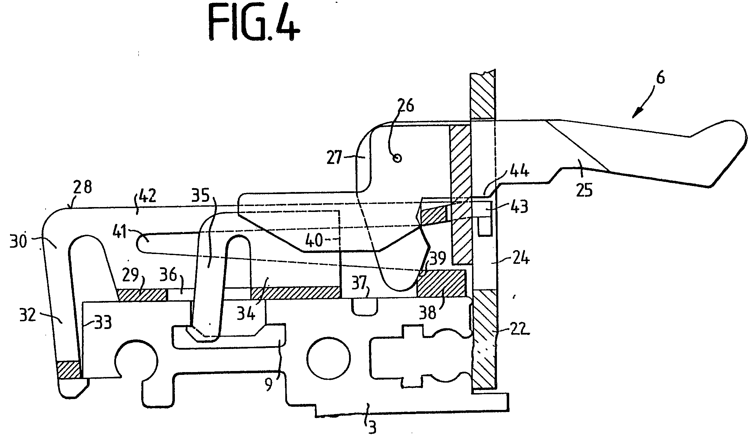

Fig. 4 einen Schnitt längs der Linien I-I der in Fig. 2 dargestellten Vorrichtung,

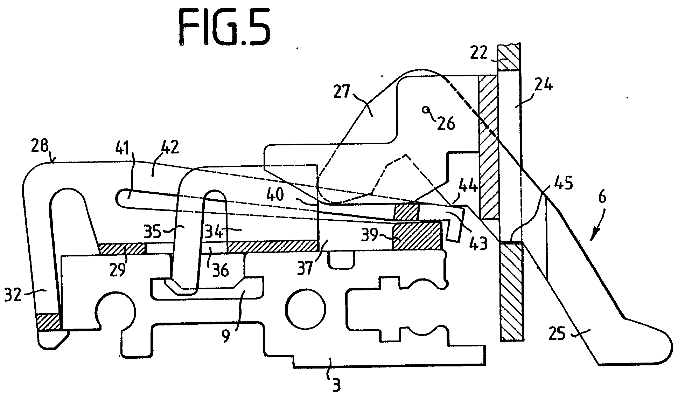

Fig. 5 die in Fig. 4 dargestellte Vorrichtung nach der Lösung der Verbindung zwischen der Steckbaugruppe und dem Baugruppenträger,

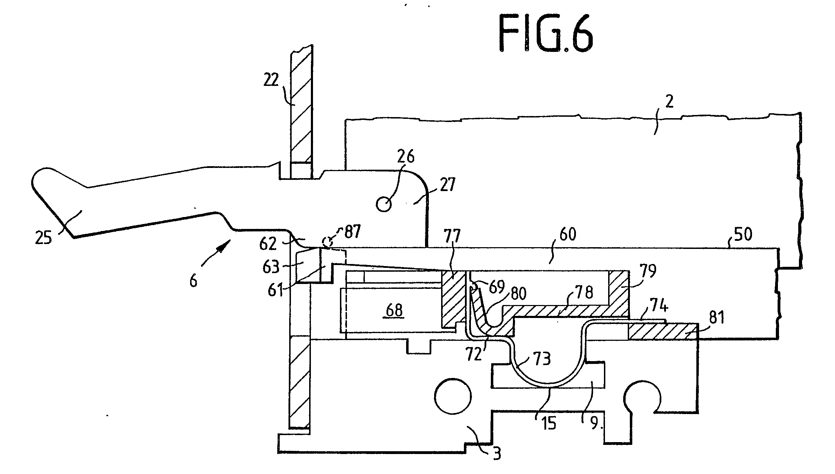

Fig. 6 einen Längsschnitt durch eine andere Ausführungsform eines Systems zum lösbaren Arretieren von in Baugruppenträgern einschiebbaren Stockbaugruppen und zum Herstellen voreilender Massekontaktverbindungen zwischen elektrisch leitenden Teilen der Steckbaugruppe und Profilschienen,

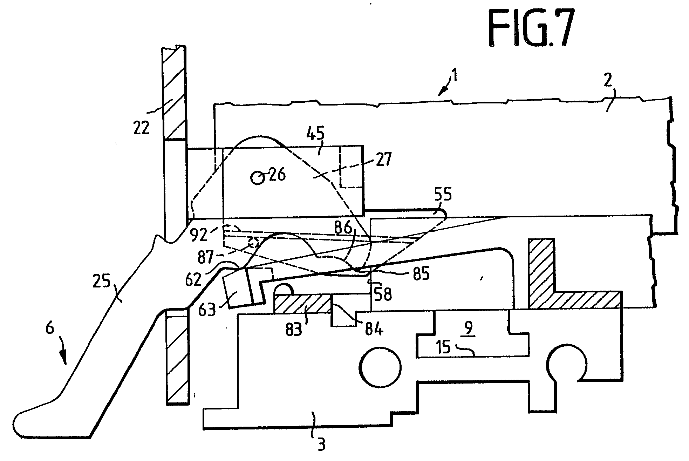

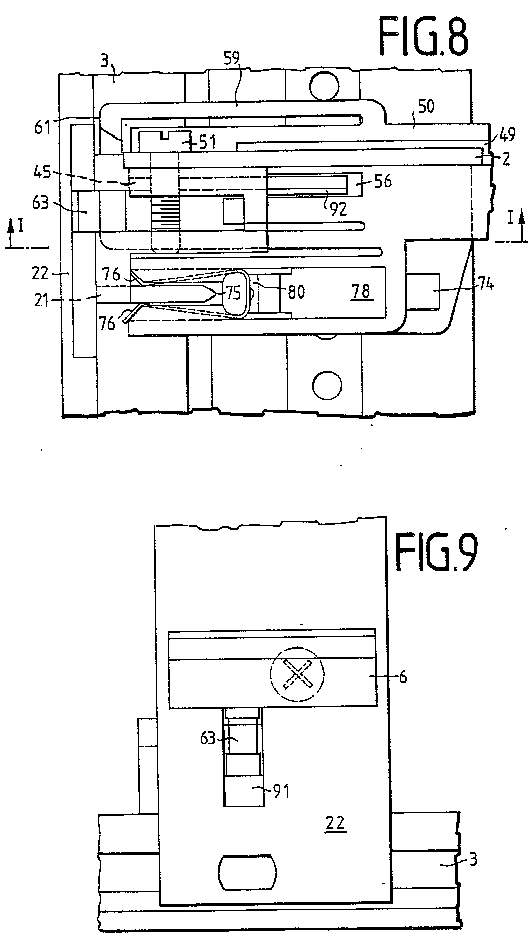

Fig. 7 das System gemäß Fig. 6 nach dem Lösen der Arretierung der Steckbaugruppen im Längsschnitt längs der Linien I-I gemäß Fig. 8,

Fig. 8 das in Fig. 6 dargestellte System von oben ohne Handbestätigungselement,

Fig. 9 das System gemäß Fig. 6 von vorne,

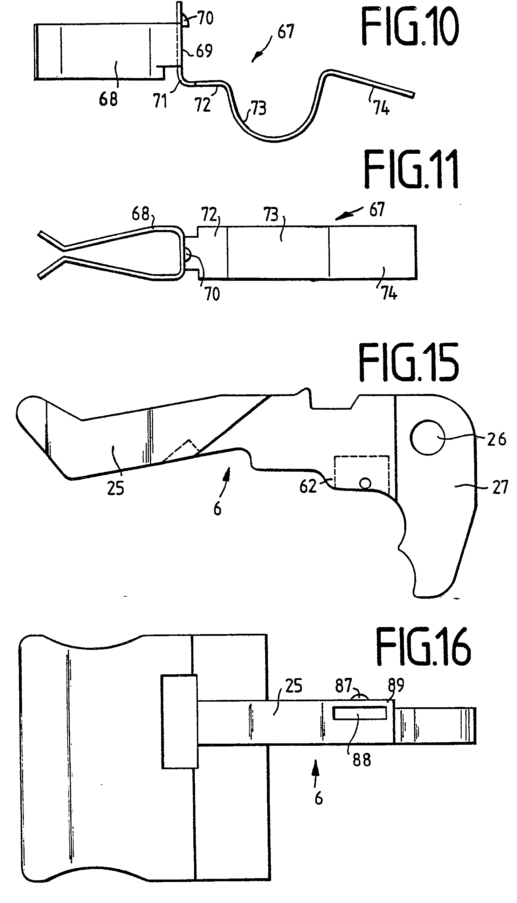

Fig. 10 eine Metallfeder in Seitenansicht,

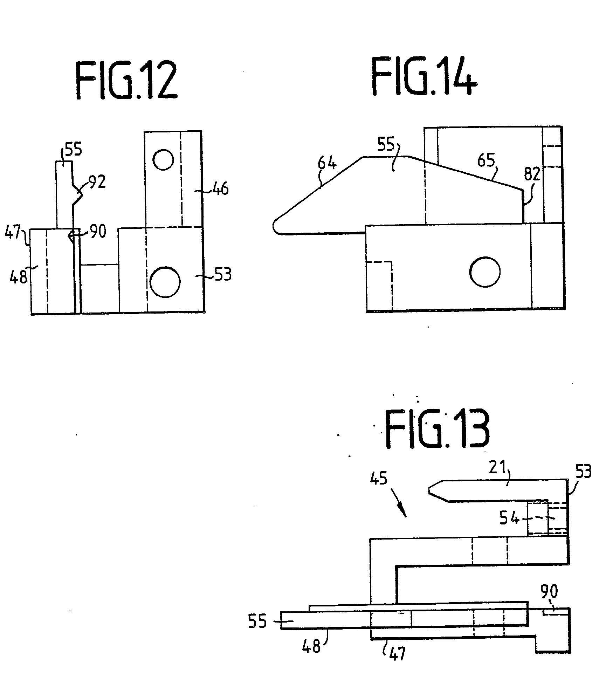

Fig. 11 die in Fig. 10 dargestellte Metallfeder von oben,

Fig. 12 ein an der Frontplatte einer Steckbaugruppe befestigter Metallbegel von vorne,

Fig. 13 von an der Steckbaugruppe gemäß Fig. 6 befestigte Metallbügel von oben,

Fig. 14 den Metallbügel gemäß Fig. 13 von der Seite,

Fig. 15 einen Winkelhebel von der Seite,

Fig. 16 den Winkelhebel gemäß Fig. 15 von oben.

Ein System zum lösbaren Arretieren von in Baugruppenträgern einschiebbaren Steckbaugruppen 1 und zum Herstellen voreilender Massekontaktverbindungen zwischen elektrisch leitenden Teilen, beispielsweise nicht näher dargestellten Leiterbahnen auf einer Leiterplatte 2 der Steckbaugruppe 1, und Profilschienen 3 des jeweiligen Baugruppenträgers umfaßt jeweils eine Metallfeder 4, einen Bügel 5 aus Metall, einen Winkelhebel 6 und einen Klemmkörper 7. Der Bügel 5 ist an der Leiterplatte 2 befestigt. Die mit Masse zu verbindenden Metallbahnen auf der Leiterplatte 2 sind mit ihren Enden an den Bügel 2 angedrückt.

Auf der Profilschiene 3, die im jeweiligen Baugruppenträger mit weiteren vier angeordnet ist, sind Führungshalter 8 befestigt. Die Führungshalter 8 können den aus der DE—B—25 54 106 ersichtlichen Aufbau haben. Sie sind an ihren Enden mit zapfenförmigen Halteelementen versehen, die in T-nutenförmige Profilausnehmungen 9 der Profilschienen 3 engreifen. Die zapfenförmigen Halteelemente bestehen jeweils aus quer zu ihrer Längsachse nachgiebigen Führungsstiften 10, die in entsprechende Löcher 11 in den Profilschienen 3 hineinragen. Weiterhin sind an den Enden der Führungsschienen 8 je zwei federnde Elemente 12 vorgesehen, die zu beiden Seiten der Führungsstifte 10 und quer zur Längsachse des Führungshalters 8 angeordnet sind und an ihren Enden vorspringende Lippen 13 aufweisen, die an den Kanten der T-förmigen Profilausnehmung 9 einrasten.

Die Profilschienen 3 haben den in Figur 3 der DE—B—26 53 468 gezeigten Querschnitt.

Die Metallfeder 4 hat ein U-förmig gebogenes Ende 14, das in die Nut 9 eingelegt ist und federnd gegen den Boden 15 sowie gegen die vorspringenden Seitenwände 16 angedrückt ist. Die Metallfeder 4 hat eine gewisse Breite, so daß eine hinteichend große Auflagefläche vorhanden ist. In der Mitte der dem Boden 15 zugewandten Fläche der Metallfeder 4 kann ein Loch als Durchlaß für den jeweiligen Führungsstift vorgesehen sein.

Der an das U-förmige Ende 14 anschließende Mittelabschnitt 17 der Metallfeder 4 liegt flach auf der Profilschiene 3 auf. Er verläuft in einem nicht näher bezeichneten Hohlraum zwischen dem vorderen Ende des Führungshalters 8 und der Profilschiene 3.

Vor der Stirneite 18 des Führungshalters 8 ist die Metallfeder 4 um 90° gebogen und ragt in dem Raum vor dem Fürhungshalter 8, der sich nicht bis an den vorderen Rand der Profilschiene 3 erstreckt. Die Metallfeder 4 gabelt sich an ihrem anderen Ende in zwei federnde Zinken 19 auf, die in den Raum zwischen der nicht näher bezeichneten unteren Seite der Leiterplatte 2 und der Profilschiene 3 ragen.

Der Bügel 5 hat in Höhe der Zinken 19 einen U-förmigen Querschnitt. Die eine äußere Seite 20 des Bügels 5 ist mit dem Winkelhebel 6 verbunden. Die andere äußere Seite 21 ist als Messerkontakt ausgebildet und ragt in die Zinken 19 hinein, die sich in eingebautem Zustand der Steckbaugruppe 1 unter einer Federkraft gegen die Seite 21 anlegen, die im folgenden auch als Messerkontakt 21 bezeichnet ist. Der Raum zwischen der Stirnseite 18 und dem vorderen Rand der Profilschiene 3 ist ausreichend lang, um den Messerkontakt 21 als langen Kontakt ausbilden zu können, der eine elektrisch leitende Verbindung mit den Zinken 19 herstellt, bevor die Kontakte der nicht dargestellten Steckverbinder am hinteren Ende der Leiterplatte eine elektrisch leitende Verbindung mit den an der Rückseite des Baugruppenträgers angeordneten Steckverbinderkontakten herstellen.

Die Steckbaugruppe 1 weist eine Frontplatte 22 auf, die am Bügel 5 mittels einer Schraube 23 befestigt ist. Die Frontplatte 22, die sich in eingebauter Lage der Steckbaugruppe 1 gegen die vorderen Stirnseiten der Profilschienen 3 legt, hat eine Aussparung 24, durch die der Winkelhebel 6 hindurchragt. Der durch die Aussparung 4 über die dem Bügel 5 abgewandte Seite der Frontplatte 22 hinausragende Hebelarm 25 des Winkelhebels 6 ist als Handhabe zum Anfassen und Schwenken ausgebildet.

Der Winkelhebel 6 ist an der Seite 20 des Bügels 5 angelenkt und um eine parallel zu den Profilschienen 3 verlaufende Achse 26 schwenkbar. Die Achse 26 befindet sich ungefähr in der Mitte derjenigen Stelle, an der der andere Hebelarm 27 in etwa unter einem rechten Winkel mit dem Hebelarm 25 zusammentrifft.

Der Winkelhebel 6 ist in einer Ebene schwenkbar, die neben dem Führungshalter 8 liegt. Der Hebelarm 27 ragt mit seinem Ende in eingebauter Stellung der Steckbaugruppe 1 bis nahe an die Profilschiene 3 heran.

Mit der Profilschiene 3 ist ein Klemmkörper 28 verbunden. Der Klemmkörper 28 hat zwei U-förmig von einem Bodenabschnitt 29 nach oben ragende Seitenteile 30, 31. Der Bodenabschnitt 29 liegt auf der Profilschiene 3 auf. Die Seitenteile 30, 31 sind jeweils mit federnden Rasthaken 32 versehen, die die hintere Stirnseits 33 der Profilschiens 3 umkreisen. In der Mitte zwischen den beiden Seitentellen 30, 31 ragt eine Platte 34 nach oben, die einen federnden Rasthaken 35 enthält, der durch eine Öffnung 36 im Boden 39 hindurchragt. Der Rasthaken 35 ragt so weit über die Unterseite des Bodens 29 hinaus, daß seine Spitze die hintere Seitenwand 16 der T-förmigen Profilausnehmung 9 umgreift. Damit blockieren die Rasthaken 32 und 35 eine Bewegung des Klemmkörpers 28 in Verschieberichtung der Steckbaugruppe 1.

Der Boden 29 ragt bis nahe an die vordere Kante der Profilschiene 3 heran. Im Boden 29 befindet sich eine weitere Aussparung 37. Die Aussparung 37 läßt im Bereich der vorderen Kante der Profilschiene 3 einen stärkeren Abschnitt 38 übrig, dessen innere Wand 39 eine Anschlagfläche für den Hebelarm 27 bildet.

Eine weitere Anschlagfläche ist eine Stirnseite 40 der Platte 34. Diese Stirnseite 40 überragt eine Seite der Aussparung 37.

Die beiden Seitenteile 30, 31 sind mit Schlitzen 41 versehen, durch die federnde Seitenarme 42 eines Bügels 43 gebildet werden, der den Hebelarm 27 umgibt. Der Bügel 43 ragt vorzugsweise mit seinem Ende in die Aussparung 24 hinein.

Am Hebelarm 25 ist eine Kante 44 vorgesehen, die sich beim Schwenken des Winkelhebels 6 gegen den Bügel 43 legt.

Die Figur 4 zeigt den Winkelhebel 6 in einer Stellung, in der die Steckbaugruppe 2 in ihrer Betriebsstellung in Baugruppenträger angeordnet ist. In dieser Stellung hat der Hebelarm 25 ungefähr eine waagrechte und der Hebelarm 27 ungefähr eine senkrechte Position. Das Ende des Hebelarms 27 liegt an der einen inneren Wand 39 der Aussparung 37 an. Der Bügel 43 rastet hinter eine Kante des Metallbügels ein und verhindert, daß sich die mit ihm verbundenen Teile durch auf die Steckausgruppe ausgeübte Kräfte lösen können.

Um die Steckbaugruppe 1 aus ihrer Halterung im Baugruppenträger zu lösen, wird der Hebelarm 25 von Hand nach unten gedrückt. Der Winkelhebel 6 wird dabei um die Achse 26 geschwenkt, wobei sich die Spitze des Hebelarms 27 von der Wand 39 entfernt und sich gegen die Stirnseite 40 legt.

Über den Winkelhebel 6 wird auf die Stirnseite 40 eine Kraft ausgeübt, unter deren Wirkung sich die Steckverbinder an der Rückseite des Baugruppenträgers und an dem hinteren Ende der Steckbaugruppe 1 lösen, wobei sich die Steckbaugruppe ein Stück nach vorne verschiebt. Während der Schwenkbewegung wird der Bügel 43 durch die Kante 44 nach unten gedrückt und gibt dabei den Verschiebeweg des Bügels und und der mit ihm verbundenen Fronplatte und Steckbaugruppe frei.

In der in Fig. 5 gezeigten Stellung hat sich die Steckbaugruppe 1 so weit nach vorne bewegt, daß die Steckverbinder am hinteren Ende der Leiterplatte 2 und an der Rückseite des Baugruppenträgers voneinander getrennt sind. Der Messerkontakt 21 steht ebenfalls nicht mehr mit den Zinken 19 in Verbindung. Die über den Winkelhebel 6 ausgeübte Kraft bewirkt also eine Trennung der elektrisch leitenden Verbindungen. Danach wird die Steckbaugruppe 1 nur noch von den oberen und unteren Führungshaltern 8 in ihrer Position gehalten. Sie kann von Hand leicht aus den Führungshalten 8 herausgezogen werden. Die Figur 5 zeigt diejenige Stellung des Winkelhebels 6, in der der Hebelarm 25 seine tiefste Position eingenommen hat. In dieser Position legt sich ein Absatz 45 gegen die untere Seite der Aussparung 24.

Die in Figur 5 gezeigte Position ist auch der Ausgangspunkt für das Zusammenfügen der Steckverbinder der Steckbaugruppe 1 und der Rückseite des Baugruppenträgers. Die erforderliche Kraft wird von dem Hebelarm 27 ausgeübt, der sich beim Anheben des Hebelarm 25 gegen die Wand 39 legt. Dabei wird die Steckbaugruppe 1 in den Führungshaltern 8 nach hinten bewegt.

Die Seite 20 ist als besonderer Bügel mit einer schrägen Auflauffläche ausgebildet, der beim Einschieben der Steckbaugruppe 1 den Bügel 43 nach unten drückt. Der besondere Bügel ist nach an dem Hebelarm 27 mit einer Aussparung versehen, die es zuläßt, daß der Bügel 43 nach oben federn kann und dabei die Arreiterung der Steckbaugruppe bewirkt.

In den Fig. 6 bis 15 ist eine andere Ausführungsform eines Systems zum lösbaren Arreiteren von in Baugruppenträgern einschiebbaren Steckbaugruppen und zum Herstellen voreilender Massekontaktverbindungen zwischen elektrisch leitenden Teilen der Steckbaugruppe und Profilschienen dargestellt. Gleiche Teile sind in den Fig. 1 bis 9 mit den gleichen Bezugszeichen versehen.

Die Leiterplatte 2 ist gemäß Fig. 6 bis 9 an einem Metallbügel 45 z.B. mittels einer nicht näher bezeichneten Schraube befestigt. Der Metallbügel 45 hat ein U-förmiges Basisteil 46, das so an der Frontplatte 22 der Steckbaugruppe befestigt ist, daß die äußere Seite 47 des einen Schenkels 48 mit einer Wand einer Führungsnut 49 eines Führungshalters 50 fluchtet, der mit der Profilschiene 3 verbunden ist. An der Seite 47 ist die Leiterplatte 2 befestigt. In der Mitte des Metallbügels 45 ist der Winkelhebel 6 schwenkbar gelagert. Der Winkelhebel 6 weist z.B. eine Bohrung auf, durch die der Schaft einer in den Metallbügel 45 eingesetzten Schraube 51 hindurchragt. Der zweite Schenkel 52 des Basisteils 46 hat an seinem freien Ende einen seitlichen Vorsprung 53, der rechtwinklig zum Schenkel 52 verläuft. In dem Vorsprung 53 ist eine Bohrung 54 vorgesehen, in die eine Schraube zum Befestigen des Metallbügels 45 an der Frontplatte 22 eingesetzt wird. Vom Ende des Vorsprungs 53 geht der Messerkontakt 21 aus, der in etwa parallel zu den Schenkeln 48 und 52 verläuft. Der Metallbügel 45 enthält eine das Joch überragende Führungsplatte 55, die vom Schenkel 48 ausgeht. Die Führungsplatte 55 sitzt auf der oberen Schmalseite des Schenkels 48 und verläuft mit ihren Breitseiten parallel zur Seite 47. Im Führungshalter 2 ist nahe an der Stirnseite 18 eine weitere Führungsnut 56 vorgesehen, die parallel zu der Führungsnut 49 verläuft, jedoch gegenüber dieser nur eine geringe Länge hat. Beispielsweise hat die Führungsnut 56 eine Länge, die in etwa der Breite der Profilschiene 3 entspricht. Beim Einsetzen der Steckbaugruppe 1 in einen Steckkartenplatz eines Baugruppenträgers wird die Leiterplatte 2 in die Führungsnuten 49 eines Führungshalterpaars eingesetzt, während die Führungsplatten 58 in die Führungsnuten 56 eingreifen.

Der Führungshalter 50 enthält einen U-förmigen Bügel 57, dessen Basen je von einer Stelle der Längsseiten des Führungshalters 50 ausgehen. Gegen die Stirnseite 58 des Führungshalters 50 sind diese Stellen gegen die Mitte hin versetzt. Der Bügel 57 weist zwei Schenkel 59, 60 und ein Joch 61 auf. Die Schenkel 59, 60 verlaufen in geringem Abstand parallel zu den Längsseiten des Führungshalters 50 und erstrecken sich über die Stirnseite 58 hinaus. Die Schenkel 59, 60 und das Joch 61 haben nur einen Bruchteil der Höhe des Führungshalters 50. Die Schenkel 59, 60 liegen mit ihren Fußpunkten in Höhe der den Profilschienen 3 abgewandten Seite der Führungshalter 50. Die Bügel 57 sind federnd ausgebildet. Sie bestehen ebenso wie der gesamte Führungshalter 50 aus Kunststoff.

In entspannter Stellung erstreckt sich der Bügel 57 in Höhe der den Profilschienen 3 abgewandten Seite des Führungshalters 50. Die Fig. 6 zeigt den Bügel 57 in dieser Stellung in Seitenansicht. Diese Stellung nimmt der Bügel 57 ein, wenn die Steckbaugruppe vollständig in den Baugruppenträger eingesetzt ist. Hierbei liegt die Frontplatte 22 an den Stirnseiten der oberen und unteren Profilschienen 3 des Baugruppenträgers an. In der in Fig. 6 dargestellten Lage der Steckbaugruppe ragen die Schenkel 48 und 52 in den Raum vor der Stirnseite 58 des Führungshalters oberhalb der Profilschiene 3. Der Übersichtlichkeit halber ist der Metallbügel in Fig. 6 jedoch nicht dargestellt. In vollständig eingesetzter Stellung der Steckbaugruppe haben die Hebelarme 25 und 27 die in Fig. 6 dargestellte Position. Der Hebelarm 25 erstreckt sich mit seiner Längsachse in etwa parallel zur Längsachse des Führungshalters 50. Der Hebelarm 27 ist mit seiner Längsachse etwa senkrecht zur Längsachse des Hebelarms 25 ausgerichtet.

Dabei befindet sich der Hebelarm 27 zwischen den Schenkeln 48 und 52 des Bügels 46.

Die Höhe des Metallbügels 46 übertrifft die Höhe des Führungshalters 50. Die Schwenkachse 26 des Winkelhebels 6 befindet sich in dem Bereich des Metallbügels 46, der den Führungshalter 50 überragt.

Wenn der Hebelarm 25 nach unten gedrückt wird, legt sich ein Vorsprung 62 gegen das Joch 61 bzw. einen verbreiterten, vorspringenden Abschnitt 63 des Jochs 61. Dabei wird das Joch 61 des federnden Bügels 57 nach unten gedrückt. Zugleich legt sich das Ende des Hebelarms 27 gegen die Stirnseite 58 des Führungshalters 50 an. Die in dem Fig. 6 bis 16 dargestellte Vorrichtung ist bei jeder Steckbaugruppe paarweise vorhanden. Die Führungshalter sind hierbei jeweils an der oberen und unteren Profilschienen des Baugruppenträgers angebracht. Dem unteren Führungshalter 50 entspricht ein spiegelsymmetrisch ausgeführter Führungshalter an den oberen Profilschienen. Um eine in den Baugruppenträger eingesetzte Steckbaugruppe herauszuziehen, müssen die Winkelhebel 6 und der nicht dargestellte obere Winkelhebel nach unten bzw. oben gedrückt werden. Der Ablauf des Herausziehens wird im folgenden anhand der Fig. 6 bis 8 beschrieben. An der oben an der Frontplatte 22 befestigten Ein- und Ausziehhilfsmittel spielen sich spiegelsymmetrisch zur mittleren Längsachse der Leiterplatte die gleichen Vorgänge ab.

Wenn sich das Ende des Hebelarms 27 gegen die Stirnseite 58 gelegt hat, muß auf den Hebelarm 25 ein verstärkter Druck ausgeübt werden, der eine auf die Stirnseite 58 und den Metallbügel 46 einwirkende Kraftkomponente in Längsrichtung des Führungshalters 50 hervorruft. Ist diese Kraftkomponente so groß, daß sie die Reibung zwischen den Kontakten der Steckverbinder der Leiterplatte und der Rückseite des Baugruppenträgers sowie die Reibung zwischen dem Messerkontakt 21 und den später noch eingehender beschriebenen Federkontakten und die Reibung der Leiterplatte 2 in der Führungsnut bzw. die Reibung zwischen der Führungsplatte 55 auf dem Joch 61 des federnden Bügels 57 überwindet, dann bewegt sich die Steckbaugruppe aus dem Baugruppenträger heraus. Der Vorsprung 62 drückt das Joch 61 so weit beiseite, daß der Metallbügel 57 mit der Leiterplatte 2 über das Joch 61 hinwegbewegt werden kann. Wenn sich die Verbindungen der Steckkontakte gelöst haben, ist die Steckbaugruppe leicht aus den Führungshaltern herauszuziehen. Die Fig. 7 zeigt die Steckbaugruppe in einer teilweise gegen die Endlage im Baugruppenträger verschobenen Stellung.

Beim Einfügen einer Steckbaugruppe legt sich eine schräge Seite 64 der Führungsplatte 55 gegen den vorspringenden Abschnitt 63, der leicht abgeschrägt ist. Hierdurch wird das Joch 61 mit den Schenkeln 59 und 60 beiseite gedrückt, so daß die Leiterplatte 2 in die Führungsnut des Führungshalters 50 eingeschoben werden kann. Das Einschieben der Leiterplatte 2 wird hierdurch wesentlich erleichtert. Die Führungsplatte 55 hat eine weitere schräge Seite 65, die der Frontplatte 22 zugewandt ist. Die schräge Seite 65 läßt es zu, daß das Joch 61 wieder in die Ruhelage zurückkehrt, wenn die Leiterplatte 2 zum größten Teil in die Führungshalter eingeschoben ist. Die Führungsplatte 55 weist im Anschluß an die schräge Seite 65 einen senkrecht zur Profilschiene 3 verlaufenden Absatz 82 auf. In eingeschobener Stellung der Steckbaugruppe 1 rastet das Joch 61 hinter dem Absatz 82 der Führungsplatte 55 ein und verriegelt damit die Steckbaugruppe 1 in eingeschobenem Zustand. Zum Überwinden der Federkräfte zwischen den Steckverbinderkontakten ist es günstig, den Winkelhebel 6 zu verwenden. Der Hebelarm 25 wird hierzu nach oben gedrückt, wobei sich das Ende des Hebelarms 27 an die Innenseite des Jochs 61 legt. Durch weitere Kraftausübung auf den Hebelarm 25 wird eine Kraft auf die Leiterplatte 2 übertragen. Die Kraft reicht aus, um die Kontakte der Steckverbinder zusammenzufügen. Vom Führungshalter 50 geht ein weiterer Bügel 83 aus, der unterhalb des Niveaus des Bodens der Führungsnut 49 verläuft und mit einer Seite an der Profilschiene 3 anliegt. Die Bügel 89 verläuft vor der Stirnseite 58 des Führungshalters 50. Er kann zweckmäßigerweise einen formschlüssig in eine Ausnehmung der Profilschiene 3 eingreifenden, vorspringenden Teil haben. Der Bügel 83 ist an seiner der Stirnseite 58 zugewandten Innenseite 84 als Anschlagfläche für das freie Ende des Winkelarms 27 ausgebildet. Das Ende des Winkelhebels 27 ist als Kante 85 ausgebildet, die durch eine konkave Aussparung 86 am Winkelarm 27 erzeugt wird. Die konkave Aussparung 86 an der Innenseite des rechtwinklig zum Hebelarm 25 verlaufenden Hebelarm 27 erfüllt eine mehrfache Aufgabe. Beim Einschieben der Steckbaugruppe 1 legt sie sich an das Joch 61 an und ermöglicht das Einschieben in der Phase vor der Verbindung der Kontakte der Steckverbinder. Danach wird die Kante 85 gegen die Innenseite 84 gedrückt, wobei Kräfte in Achsrichtung des Führungshalters 50 wirken, wodurch sich unerwünschte Beanspruchungen und damit Verformungen des Führungshalters 50 vermeiden lassen. In eingeschobenem Zustand der Steckbaugruppe 1 liegt die Kante an der Innenseite 84 an.

Von besonderer Bedeutung ist der geringe Abstand zwischen der Leiterplatte 2 und dem Winkelhebel 6. Beide Teile sind nur durch den der Stärke des Schenkels 48 entsprechenden Abstand voneinander getrennt. Da der Schenkel 48, wie der gesamte Bügel 46, aus Metall besteht, kann auch bei geringer Stärke eine hohe Festigkeit erzielt werden. Aufgrund des geringen Abstands werden kaum Seitenkräfte beim Ein- und Ausziehen der Leiterplatte 2 auf diese ausgeübt. Hierdurch wird das Zusammenfügen und Lösen der Kontakte der Steckverbinder der Leiterplatte 2 und der Rückseite des Baugruppenträgers erheblich erleichtert.

Nahe am vorderen Ende des Führungshalters 50 befindet sich an einer Seite ein Haltekörper 66 für eine Kontaktfeder 67, deren Gestalt ausführlicher in den Fig. 10 und 11 erkennbar ist. Die Kontaktfeder 67 enthält einen bügelförmigen Kontaktabschnitt 68, in den der Messerkontakt 21 eingesteckt wird. Die Rückseite 69 des bügelförmigen Kontaktabschnitts 68 ist mit einer Noppe 70 versehen. An einem Ende 71 ist die Rückseite 69 um 90° abgewinkelt und geht in einen ebenen Abschnitt 72 über, an den sich ein halbkreisförmiger Bogen 73 anschließt. An das Ende des Bogens 73 schiebt sich ein weiterer ebener Abschnitt 74 an.

Der Haltekörper 66 befindet sich in Längsrichtung des Führungshalters 50 vor dem sietlichen Vorsprung 54. Gegen die Frontplatte 22 hin hat der Haltekörper eine quaderförmige Aussparung 75. In die Aussparung 75 ragen die vorderen, abgewinkelten Enden 76 des Kontaktabschnitts 68 hinein. Zwischen die Enden 76 wird der Messerkontakt 21 eingeschoben. Die der Rückseite 69 benachbarten Teile des Kontaktabschnitts 68 sind in nicht näher bezeichnete, schräge zur Längsachse sich erweiternde Hohlräume des Haltekörpers 66 eingesetzt. Am inneren Ende der Aussparung 75 befindet sich eine Wand 77, gegen deren, der Aussparung 75 abgewandte Seite die Rückseite 69 angelehnt ist. Der Haltekörper 66 enthält eine in eine Ausnehmung ragende Federplatte 78, die von einer rückwärtigen Wand 79 ausgeht und bis zu der Rückseite 69 heranragt. Die Federplatte 78 ist mit einem Hakenende 80 versehen, dessen Stirnseite gegen den Noppen 70 anliegt. Die Kontaktfeder 67 wird auf diese Weise im Haltekörper 66 eingespannt. Die Federplatte 78 erstreckt sich in einem gewissen Abstand von der Ebene der Auflageseite des Führungshalters 50 ungefähr paralle zu dieser Ebene. Das Hakenende 80 ragt mit seinem gekrümmten Abschnitt bis in die Höhe der Ebene der Auflageseite des Führungshalters 50. Am rückwärtigen Ende des Haltekörpers 66 befindet sich wieterhin eine Auflageplatte 81, deren Auflagefläche sich in Höhe der Ebene der Auflageseite des Führungshalters 50 erstreckt. Zwischen der oberen Seite der Auflageplatte 81 und dem unteren Ende der Wand 79 befindet sich ein Zwichenraum, dessen Weite auf die Stärke des Abschnitts 74 der Kontaktfeder 67 abgestimmt ist. In diesen Zwischenraum ragt der Abschnitt 74 hinein. Damit wird die Kontaktfeder 67 an einer weiteren Stelle gehalten. Die Kontaktfeder 67 bildet mit dem Führungshalter 50 eine für sich handhabbare Einheit, die vor der Montage an den Profilschienen 3 zusammengesetzt wird.

Der Bogen 73 wird unter Federvorspannung an die vorspringenden Wände und den Boden 15 der Profilausnehmung 9 angedrückt. Dabei stellt sich je eine geringe Formänderung ein, durch die sich größere Auflageflächen ergeben. Der Abschnitt 72 wird zwischen dem Hakenende 80 und der Auflagefläche der Profilschiene 3 eingeklemmt. Zwischen der metallischen Profilschiene 3 und der Kontaktfeder 67 ergeben sich daher geringe Übergangswiderstände. Durch die Ausbildung einer entsprechend starken Federvorspannung der Kontaktabschnitte 68 läßt sich auch ein niedriger Übergangswiderst und zwischen der Kontaktfeder 67 und dem Metallbügel 46 erzielen, der mit Leiterbahnen auf der Leiterplatte 22 verbunden sein kann. Ein wesentlicher Vorteil ergibt sich bei der Verbindung des Metallbügels 46 mit einer metallischen Frontplate 22. Einerseits wird hierdurch eine höhere Sicherheit erreicht; andererseits eignet sich die metallische Frontplatte auch zum Abschirmen. Die Länge des Messerkontaktes 21 und die Tiefe der Aussparung 75 nebst der Länge der Kontaktabschnitte 68 sind so bemessen, daß zuerst der Messerkontakt 21 die Kontaktabschnitte 68 berührt, bevor die Kontakte der nicht näher dargestellten Steckverbinder am rückwärtigen Ende der Leiterplatte 2 und der Rückseite des Baugruppenträgers einander berühren, wenn die Steckbaugruppe in den Baugruppenträger eingesetzt wird. In entsprechender Weise lösen sich die Kontakte der Steckverbinder der Leiterplatte 2 und an der Rückseite des Baugruppenträgers beim Herausziehen der Steckbaugruppe vor der Tennung des Messerkontakts 21 und der Kontaktfeder.

Die leitende Verbindung zwischen den an den Metallbügel angeschlossenen Leiterbahnen der Leiterplatte bzw. der Frontplatte 22 und der Profilschiene 3 wird deshalb beim Einsetzen der Steckbaugruppe vor allen anderen Kontaktverbindungen hergestellt und beim Herausziehen der Steckbaugruppe nach allen anderen Kontaktverbindungen gelöst. Mit der oben beschriebenen Vorrichtung läßt sich daher ein besserer Schutz gegen eine unbeabsichtigte Beaufschlagung leitender Teile der Leiterplatte 2 durch Spannungen erreichen bzw. ein den VDE-Bestimmungen entsprechender Berührungsschutz einer metallischen Frontplatte 22 erreichen.

Der oben erläuterte Führungshalter 50 kann wahlweise auch ohne Kontaktfeder 67 und ohne eine mit einem Metallbügel 46 und einen Winkelheber 6 versehene Frontplatte 22 verwendet werden. Es ist auch möglich, den Führungshalter 50 neben Führungshaltern der aus der DE—PS 25 54 106 beschriebenen Art in Baugruppenträgern zu verwenden.

Wie oben bereits erwähnt, sind die für eine Leiterplatte 2 notwendigen Führungshalter an den oberen und unteren Profilschienen spiegelsymmetrisch ausgebildet. Wenn der Übergangswiderstand zwischen den Profilschienen 3 und den entsprechenden Leiterhabnen auf der Leiterplatte noch weiter herabgesetzt werden soll, dann kann auch in den oberen Führungshalter eine Kontaktfeder 67 eingesetzt werden. Der Winkelhebel 6 weist am Hebelarm 25 einen seitlichen runden Vorsprung 87 auf, der sich in etwa parallel zu der Drehachse 26 erstreckt. Im Winkelhebel 6 ist gegenüber dem Vorsprung 87 nach innen versetzt eine Ausnehmung 88 vorhanden, durch die ein dünner Wandabschnitt 89 erzeugt wird. Hiermit wird eine elastische Beweglichkeit des Vorsprungs in dessen Längsrichtung erreicht. Bei der Schwenkung des Winkelhebels 6 beschreibt der Vorsprung 87 einen Kreisbogen, in den ein Stück des Schenkels 48 hineinragt. Der Schenkel 48 weist im Bereich der Kreisbahn eine Ausnehmung 90 auf, in die der Vorsprung 87 einrastet, wenn sich die Steckbaugruppe 1 in eingeschobenem Zustand befindet, in den der Hebelarm 25 waagrecht steht. Ob eine Steckbaugruppe 1 ihre Endstellung im Führungshalter 50 erreicht hat, ist auch an einem Fenster 91 in der Frontplatte 22 der Steckbaugruppe 1 zu erkennen. Das Fenster 91 gibt die Sicht auf das Joch 61 des Bügels 57 frei, der waagrecht steht, wenn die Steckaugruppe 1 verriegelt ist.

Für den Vorsprung 87 ist eine weitere Raststellung vorgesehen. Diese Raststellung wird durch einen Rastvorsprung 92 bework, der von der Führungsplatte 55 ausgeht und eine Art Längsschiene bildet, die sich über die Länge der Führungsplatte in einem bestimmten Abstand von der Auflageseite der Profilschiene 3 erstreckt. Der Rastvorsprung 92 ist so weit von der Profilschiene 3 entfernt, daß der Vorsprung 87 in schräger Stellung des Winkelhebels 6, wie sie in Fig. 7 dargestellt ist, auf der der Profilschiene 3 zugewandeten Seite des Rastvorsprungs 92 eingerastet ist. Von Bedeutung ist diese Stellung für den oben an der Steckbaugruppe 1 über den Metallbügel 45 befestigten Winkelhebel 6. Der Winkelhebel 6, der an der oberen Seite der Steckbaugruppe befestigt ist, wird durch den Rastvorsprung 92 in seiner schrägen Position gehalten. Die Winkelhebel 6 an der oberen und unteren Ecke der Steckbaugruppe bleiben daher in denjenigen Positionen, in denen die Hebelarme 25 auseinandergespreizt sind. In diesen Positionen sind die Kontakte der Steckverbinder an der rückwärtigen Seite der Steckbaugruppe von den Kontakten der Gegensteckelemente des Baugruppenträgers gelöst. Die Steckbaugruppe kann daher von Hand leicht aus den Führungshaltern 50 herausgezogen werden.

**Patentansprüche**

1. System zum Einschieben und Herausziehen von in Baugruppenträger einschiebbaren Steckbaugruppen (1), deren Längsränder je in eine Nut eines oberen und eines unteren Führungshalters (8) einsetzbar sind und die in eingeschobenen, Zustand durch einen Winkelhebel (6) am Baugruppenträger arretierbar sind, dessen einer Hebelarm (25) als Handhabe ausgebildet ist und der an der Seite eines an der jeweiligen Steckbaugruppe befestigten Metallbügels (5, 45) schwenkbar befestigt und mit dem anderen Hebelarm an Anschlagflächen andrückbar ist, wobei in eingeschobenem Zustand der jeweiligen Steckbaugruppe (1) zur Herstellung einer voreilenden Massenkontaktverbindung zwischen elektrisch leitenden Teilen der Steckbaugruppe (1) und Profilschienen (3) des Baugruppenträgers ein Messerkontakt (21) des an der Steckbaugruppe (1) befestigten Metallbügels (5, 45) mit einer leitend mit der Profilschiene verbundenen Metallfeder (4, 67) in Kontakt steht, dadurch gekennzeichnet, daß die Metallfeder (4, 67) zwischen dem einen Ende des Führungshalters (8) und der Profilschiene (3) eingespannt ist und einen gabelförmig ausgebildeten, nach vorne offenen Federkontakt (19) aufweist, der im Raum vor der gegen den äußeren Rand der Profilscheine (3) zurückgesetzten Stirnseite (18) des Führungshalters (8) angeordnet ist.

2. System nach Anspruch 1, dadurch gekennzeichnet, daß die Metallfeder (4) einen U-förmigen Abschnitt (14) enthält, der unter Federvorspannung in eine Profilausnehmung (9) der Profilschiene (3) eingedrückt ist, deren Boden Löcher (11) enthält, in die Führungsstifte (10) der Führungshalter (8) ragen.

3. System nach einem der vorhergehenden Ansprüche, dadurch gekennzeichnet, daß neben dem jeweiligen Führungshalter ein Klemmkörper (28) an der Profilschiene (3) befestigt ist, der je eine beim Einschieben und Herausziehen des Baugruppenträgers mit dem einen Ende des Winkelhebels (6) in Berührung stehende Andrückfläche enthält.

4. System nach einem der vorhergehenden Ansprüche, dadurch gekennzeichnet, daß der Klemmkörper (28) mindestens einen die rückwärtige Seite der Profilschiene (3) umgreifenden, federnden Rasthaken (32) und einen gegen einen der Rückseite benachbarten Vorsprung der T-förmigen Profilausnehmung (9) angedrückten Rasthaken (35) aufweist.

5. System nach einem der vorausgehenden Ansprüche, dadurch gekennzeichnet, daß der Klemmkörper (28) einen federnden Bügel (43) aufweist, in dessen Öffnung der eine Hebelarm (27) ragt, und daß am anderen Hebelarm (25) eine Kante (44) angeordnet ist, mit der der Bügel (43) aus dem Verschiebeweg des Winkelhebels (6) herausdrückbar ist.

6. System nach einem der vorausgehenden Ansprüche, dadurch gekennzeichnet, daß die Frontplatte (22) eine Aussparung (24) enthält, durch die ein Hebelarm (25) des Winkelhebels (6) ragt.

7. System nach Anspruch 1, dadurch gekennzeichnet, daß der Metallbügel (45) an der Frontplatte (22) der Steckbaugruppe (1) befestigt ist und einen auf seiner Außenseite mit einer Wand der Führungsnut (49) des Führungshalters (50) fluchtenden Schenkel (48) aufweist, an dem die in die Führungsnut (49) einsetzbare Leiterplatte (2) anliegt, und daß an die Innenseite des Schenkels (48) der Winkelhebel (6) angrenzt.

8. System nach Anspruch 1 oder 7, dadurch gekennzeichnet, daß der Führungshalter (50) eine gegen den Rand der Profilschiene (3) zurückgesetzte Stirnseite (58) als eine Anschlagfläche für das Ende des einen Hebelarms (27) des Winkelhebels (6) und einen in Hohe der Profilschiene (3) abgewandten Seite vom Führungshalter (50) vorspringenden, die Stirnseite (58) umgreifenden, federnden Bügel (57) aufweist, dessen Jochinnenseite als andere Anschlagfläche für das Ende des Hebelarms (27) ausgebildet ist, und daß das Joch (61) des Bügels (57) mit dem anderen Hebelarm (25) in der Auszeihlage des Winkelhebels (6) in Richtung der Profilschiene (3) drückbar ist.

9. System nach Anspruch 8, dadurch gekennzeichnet, daß das Joch (61) einen vorspringenden Abschnitt (63) als Anschlagfläche für einen Vorsprung (62) aufweist, der am anderen Hebelarm (25) vorgesehen ist, der in verriegelter Lage der Stechbaugruppe (1) waagrecht steht.

10. System nach Anspruch 1 oder einem der Ansprüche 7 bis 9, dadurch gekennzeichnet, daß der federnde Bügel (57) in eingeschobenem Zustand der Steckbaugruppe (1) an einen Absatz (82) des Metallbügels (45) eingerastet ist.

11. System nach Anspruch 1 oder einem der Ansprüche 7 bis 10, dadurch gekennzeichnet daß der Metallbügel (45) eine Führungsplatte (55) aufweist, die eine schräge vorspringende Seite (64) als Anschlagfläche für das Joch (61) des Bügels (57) aufweist, der beim Einschieben der Steckbaugruppe (1) aus dem Verschiebeweg der Steckbaugruppe (1) entfernt ist.

12. System nach Anspruch 1, dadurch gekennzeichnet, daß die Führungsplatte (55) in eingesetzter Stellung der Steckbaugruppe (1) in eine Nut (64) des Führungshalters (50) ragt.

13. System nach Anspruch 1 oder einem der Ansprüche 7 bis 12, dadurch gekennzeichnet, daß der Führungshalter (50) an einem Ende einen seitlich vorspringenden Haltekörper (66) für die Metallfeder (67) aufweist, deren Federkontakte in einer gegen die Baugruppenfrontseite hin offenen Aussparung (75) angeordnet sind und deren von den Federkontakten abgesetzte Abschnitte (72, 73, 74) einen in eine Nut (9) der Profilschiene (3) ragenden, den Boden (15) der Nut (9) berührenden, federnden Boden aufweist, an dessen beiden angrenzenden Abschnitten die Metallfeder (67) eingespannt ist.

14. System nach Anspruch 1 oder einem der Ansprüche 7 bis 13, dadurch gekennzeichnet, daß die Metallfeder (46) wenigstens eine Nappe aufweist, an die ein Hakenende (80) einer Federplatte (78) des Haltekörpers (66) angedrückt ist.

15. System nach Anspruch 1 oder einem der Ansprüche 7 bis 13, dadurch gekennzeichnet, daß die Metallfeder (67) mit einem Abschnitt (74) in einem Zwischenraum im Haltekörper (66) eingesetzt ist.

16. System nach einem der vorhergehenden Ansprüche, dadurch gekennzeichnet, daß der Messerkontakt (21) in Verbindung mit der Kontaktfeder (67) beim Einsetzen und Heranziehen der Steckbaugruppe (1) aus dem Baugruppenträger länger in Kontaktverbindung ist als die Steckverbinder am rückwärtigen Ende der Leiterplatte (2) und an der Rückseite des Baugruppenträgers.

17. System nach einem der Ansprüche 7 bis 14, dadurch gekennzeichnet, daß der Führungshalter (50) einen vor der Stirnseite (58) gegen die Frontplatte der Steckbaugruppe (1) verlaufenden Bügel (83) enthält, der unterhalb des Niveaus des Bodens der Führungsnut (49) angeordnet ist, und daß die der Stirnseite (58) gegenüberstehende Innenseite des Bügels (83) die Angriffsfläche für das Ende des einen Hebelarms (27) ist, der in eingeschobener Stellung der Steckbaugruppe (1) an der Innenwand (84) anliegt.

18. System nach Anspruch 17, dadurch gekennzeichnet, daß der Hebelarm (27) an seinem freien Ende eine Kante (85) aufweist, die durch eine konkave Aussparung (86) gebildet wird und die gegen die Innenseite (84) andrückbar ist.

**Revendications**

1. Système d'insertion et d'extraction pour des composants (1) insérables dans des supports de composant, dont les bords longitudinaux sont chacun insérables dans une gorge d'un support de guidage supérieur et d'un support de guidage inférieur (8) et qui sont blocables à l'état inséré sur le support de composant, à l'aide d'un levier coudé (6), dont un bras de levier (25) est réalisé sous la forme d'une manette et qui est fixé de manière pivotante sur le côté d'un étrier métallique (5, 45) fixé sur le composant respectif et qui est pressable à l'aide de l'autre bras de levier sur des surfaces de butée, un contact à couteau (21) de l'étrier métallique de l'étrier métallique (5, 45) fixé sur le composant insérable (1) étant en contact avec un ressort métallique (4, 67) relié de manière conductrice à la glissière profilée, à l'état inséré du composant (1) respectif, en vue de constituer une liaison avancée à contact à couteau entre les parties électriquement conductrices du composant insérable (1) et des glissières profilées (3) du support de composant, caractérisé en ce que le ressort métallique (4, 67) est serré entre une extrémité du support de guidage (8) et la glissière profilée (3) et présente en contact à ressort (19) réalisé en forme de fourche et ouvert vers l'avant, qui est disposé dans l'espace situé devant la face frontale (18) du support de guidage (8) qui est en retrait vis-à-vis du bord extérieur de la glissière profilée (3).

2. Système selon la revendication 1, caractérisé en ce que le ressort métallique (4) comporte une partie en forme de U (14) qui est pressée sous précontrainte dans un évidement profilé (9) de la glissière profilée (3), dont le fond contient des trous (11) dans lesquelles passant des goupilles de guidage (10) du support de guidage (8).

3. Système selon l'une des revendications précédentes, caractérisé en ce qu'un corps de serrage (28) est fixé sur la glissière profilée (3), à côté de chaque support de guidage respectif, et contient une face de pressage qui est en contact avec une extrémité du levier coudé (6), lors de l'insertion et de l'extraction du support de composant.

4. Système selon l'une des revendications précédentes, caractérisé en ce que le corps de serrage (28) présente au moins un crochet d'encliquetage (32) élastique, entourant la face arrière de la glissière profilée (3) et un crochet d'encliquetage (35) pressé contre une saillie voisine de la face arrièrs de l'évidement profilé en forme de T (9).

5. Système selon l'une des revendications précédentes, caractérisé en ce que le corps de serrage (28) présente un étrier élastique (43), dans l'ouverture duquel passe l'un des bras de levier (27), et en ce qu'une arête (44) est disposée sur l'autre bras de levier (25), à l'aide de laquelle l'étrier (43) est susceptible d'être extrait, par la course de déplacement du levier coudé (6).

6. Système selon l'une des revendications précédentes, caractérisé en ce que la plaque avant (22) contient un évidement (24) à travers lequel passe un bras de levier (25) du levier coudé (6).

7. Système selon la revendication 1, caractérisé en ce que l'étrier métallique (45) est fixé sur la plaque avant (22) du composant insérable (1) et présente une branche (48) alignée sur sa face extérieure avec une paroi de la gorge de guidage (49) du support de guidage (50), sur laquelle appuie la plaque à circuits imprimés (2) insérable dans la gorge de guidage (48), et en ce que le levier coudé (6) est limitrophe à la face intérieure de la branche (48).

8. Système selon la revendication 1 ou 7, caractérisé en ce que le support de guidage (50) présente une face frontale (58) en retrait par rapport au bord de la glissière profilée (3), qui sert de surface de butée à l'extrémité d'un bras de levier (27) du levier coudé (6) et un étrier élastique (57) entourant la face frontale (58), faisant saillie du support de guidage (50), au niveau de la face opposée à la glissière profilée (3), étrier dont la face intérieure d'armature est réalisée sous la forme d'une autre surface de butée pour l'extrémité du bras de levier (27), et en ce que l'armature (61) de l'étrier (57) est pressable en direction de la glissière profilée (3) en position d'extraction du levier coudé (6), à l'aide de l'autre bras de levier (25).

9. Système selon la revendication 8, caractérisé en ce que l'armature (61) présente une partie (63) faisant saillie, servant de butée à une saillie (62) prévue sur l'autre bras de levier (25) qui se tient horizontalement en position verrouillée du composant insérable (1).

10. Système selon la revendication 1, ou l'une des revendications 7 à 9, caractérisé en ce qu'à l'état inséré du composant (1), l'étrier élastique (57) est encliqueté sur un décrochement (82) de l'étrier métallique (45).

11. Système selon la revendication 1, ou l'une des revendications 7 à 10, caractérisé en ce que l'étrier métallique (45) présente une plaque de guidage (55) qui comporte une face (64) faisant saillie de manière inclinée, servant de surface de butée à l'armature (61) de l'étrier (57) qui est enlevé lors de l'insertion du composant insérable (1) par la course de déplacement du composant insérable (1).

12. Système selon la revendication 1, caractérisé en ce qu'en position insérée du composant insérable (1), la plaque de guidage (55) passe dans une gorge (64) du support de guidage (50).

13. Système selon la revendication 1, ou l'une des revendications 7 à 12, caractérisé en ce que le support de guidage (50) présente à une extrémité un corps de maintien (66) faisant saillie latéralement, destiné au ressort métallique (67) dont les contacts à ressort sont disposés dans un évidement (75) ouvert vers la face avant du composant et dont des parties (72, 73, 74) en retrait des contacts à ressort présentent un fond élastique, passant dans une gorge (9) de la glissière profilée (3), touchant le fond (15) de la gorge (9), fond sur les deux parties limitrophes duquel le ressort métallique (67) est serré.

14. Système selon la revendication 1, ou l'une des revendications 7 à 13, caractérisé en ce que le ressort métallique (46) présente au moins un bouton sur lequel une extrémité de crochet (80) d'une plaque à ressort (78) du corps de maintien (66) est pressée.

15. Système selon la revendication 1, ou l'une des revendications 7 à 13, caractérisé en ce que le ressort métallique (67) est inséré par une partie (74) dans un espace intermédiaire situé dans le corps de maintien (66).

16. Système selon l'une des revendications précédentes, caractérisé en ce que le contact à couteau (21), en liaison avec le ressort de contact (67), est en liaison de contact lors de l'insertion et de l'extraction du composant (1) hors du support de composant, plus longtemps que ne l'est l'élément de liaison enfichable situé à l'extrémité arrière de la plaque à circuits imprimés (2) et sur la face arrière du support de composant.

17. Système selon l'une des revendications 7 à 14, caractérisé en ce que le support de guidage (50) contient un étrier (83), s'étendant de la face frontale (58) vers la plaque avant du composant (1), disposé au-dessous du niveau du fond de la gorge de guidage (49), et en ce que la face intérieure de l'étrier (83) qui est située en face de la face frontale (58) constitue la face d'engagement de l'extrémité de l'un des bras de levier (27) qui appuie sur la paroi intérieure (84), en position insérée du composant (1).

18. Système selon la revendication 17, caractérisé en ce que le bras de levier (27) présente à son extrémité libre une arête (85) formée par un évidement concave (86) et susceptible d'être pressée contre la face intérieure (84).

## Claims

1. System for the insertion and extraction of plug-in assemblies (1), which are insertable into assembly carriers and the longitudinal rims of which are each insertable into a respective groove of an upper and a lower guide holder (8) and which are in the inserted state arrestable at the assembly carrier by an angle lever (6), the one lever arm (25) of which is constructed as handle and which is pivotably fastened at the side of a metal bracket (5, 45) fastened at the respective plug-in assembly and urgeable by the other lever arm against abutment surfaces, wherein a blade contact (21) of the metal bracket (5, 45) fastened at the plug-in assembly (1) stands in contact in the inserted state of the respective plug-in assembly (1) with a metal spring (4, 67) conductively connected with the profile rail for the production of a leading ground connection between electrically conducting parts of the plug-in assembly (1) and profile rails (3) of the assembly carrier, characterised thereby, that the metal spring (4, 67) is clamped in between the one end of the guide holder (8) and the profile rail (3) and displays a fork-shaped, forwardly open spring contact (19), which is arranged in the space in front of that end face (18) of the guide holder (8), which is set back relative to the outer rim of the profile rail (3).

2. System according to claim 1, characterised thereby, that the metal spring (4) contains a U-shaped portion (14), which is urged under spring bias into a profile recess (9) of the profile rail (3), the base of which contains holes (11), into whvch project guide pins (10) of the guide holders (8).

3. System according to one of the preceding claims, characterised thereby, that a clamping body (28), which contains a respective pressing surface standing in contact with the one end of the angle lever (6) during the insertion and extraction of the assembly carrier, is fastened beside the respective guide holder at the profile rail (3).

4. System according to one of the preceding claims, characterised thereby, that the clamping body (28) displays at least one resilient detent hook (32) encompassing the rearward side of the profile rail (3) and a detent hook (35) urged against a projection, adjacent the rear side, of the T-shaped profile recess (9).

5. System according to one of the preceding claims, characterised thereby, that the clamping body (28) displays a resilient bracket (43), into the opening of which projects the one lever arm (27), and that an edge (44), by which the bracket (43) is urgeable out of the displacement path of the angle lever (6), is arranged at the other lever arm (25).

6. System according to one of the preceding claims, characterised thereby, that the front plate (22) contains a cut-out (24), through which projects a lever arm (25) of the angle lever (6).

7. System according to claim 1, characterised thereby, that the metal bracket (45) is fastened at the front plate (22) of the plug-in assembly (1) and displays a limb (48), which on its outward side is aligned with a wall of the guide groove (49) of the guide holder (50) and against which rests the conductor plate (2) insertable into the guide groove (49), and that the angle lever (6) adjoins the inward side of the limb (48).

8. System according to claim 1 or 7, characterised thereby, that the guide holder (50) displays an end face (58), which is set back relative to the rim of the profile rail (3), as an abutment surface for the end of the one lever arm (27) of the angle lever (6) and a resilient bracket (57), which projects from the guide holder (50) at the height of the side remote from the profile rail (3) and encompasses the end face (58) and the inward yoke side of which is constructed as other abutment surface for the end of the lever arm (27), and that the yoke (61) of the bracket (57) is urgeable in direction of the profile rail (3) by the other lever arm (25) in the extraction position of the angle lever (6).

9. System according to claim 8, characterised thereby, that the yoke (61) displays a projecting portion as abutment surface for a projection (62), which is provided at the other lever arm (25), which stands horizontally in latched position of the plug-in assembly (1).

10. System according to claim 1 or one of the claims 7 to 9, characterised thereby, that the resilient bracket (57) is in the inserted state of the plug-in assembly (1) detented at a projection (82) of the metal bracket (45).

11. System according to claim 1 or one of the claims 7 to 10, characterised thereby, that the metal bracket (45) displays a guide plate (55), which displays an obliquely projecting side (64) as abutment surface for the yoke (61) of the bracket (57), which is removed out of the displacement path of the plug-in assembly (1) on the insertion of the plug-in assembly (1).

12. System according to claim 1, characterised thereby, that the guide plate (55) in the inserted setting of the plug-in assembly (1) projects into a groove (64) of the guide holder (50).

13. System according to claim 1 or one of the claims 7 to 12, characterised thereby, that the guide holder (50) at one end displays a laterally projecting retaining body (66) for the metal spring (67), the spring contacts of which are arranged in a cut-out (75) open towards the plug-in assembly front side and the portions (72, 73, 74) of which stepped from the spring contacts display a resilient base, which projects into a groove (9) of the profile rail (3) and touches the base of the groove (9) and at both adjoining portions of which the metal spring (67) is clamped in.

14. System according to claim 1 or one of the claims 7 to 13, characterised thereby, that the metal spring (67) displays at least one knob, against which a hook end (80) of a spring plate (78) of the retaining body (66) is urged.

15. System according to claim 1 or one of the claims 7 to 13, characterised thereby, that the metal spring (67) is inserted by a portion (74) into an intermediate space in the retaining body (66).

16. System according to one of the preceding claims, characterised thereby, that the blade contact (21) is longer in contact connection with the contact spring (67) during the insertion and extraction of the plug-in assembly (1) into and out of the assembly carrier than the plug connectors at the rearward end of the conductor plate (2) and at the rear side of the assembly carrier.

17. System according to one of the claims 7 to 14, characterised thereby, that the guide holder (50) contains a bracket (83), which extends in front of the end face (58) towards the front plate of the plug-in assembly (1) and is arranged below the level of the base of the guide groove (49), and that the inward side, standing opposite the end face (58), of the bracket (83) is the engagement surface for the end of the one lever arm (27), which in the inserted setting of the plug-in assembly (1) lies against the inward wall (84).

18. System according to claim 17, characterised thereby, that the lever arm (27) at its free end displays an edge (85), which is formed as a concave recess (86) and urgeable against the inward side (84).

# FIG.1

# FIG.3

FIG.2

FIG.4

# FIG.5

EP 0 196 555 B1

# FIG.6

EP 0 196 555 B1

FIG.7

EP 0 196 555 B1

FIG.8

FIG.9

7

FIG.10

70

67

69

68 71 72 73 74

FIG.11

68 72 73 67

70 74

FIG.15

26

25 62 27

6

FIG.16

25 87 89

88

6

# FIG.12

# FIG.14

# FIG.13